# FASCICULE DE BREVET EUROPEEN

(11) **EP 0 920 634 B1**
(45) Date de publication et mention de la délivrance du brevet: **04.07.2001**
(21) Numéro de dépôt: 97919478.4
(22) Date de dépôt: 03.04.1997
(51) Int. Cl.: G01R 7/06, G01D 1/16, G01D 11/24

(54) **DISPOSITIF MOTEUR A COMMANDE ELECTROMAGNETIQUE, NOTAMMENT LOGOMETRE**
ELEKTROMAGNETISCH GESTEUERTER MOTOR, INSBESONDERE LOGOMETER
ELECTROMAGNETIC CONTROL MOTOR DEVICE, PARTICULARLY A RATIO METRE

(30) Priorité: 05.04.1996 FR 9604322
(43) Date de publication de la demande: 09.06.1999
(73) Titulaire: MAGNETI MARELLI FRANCE, 92000 Nanterre (FR)
(72) Inventeur: QUELO, Vincent, F-92000 Nanterre (FR)
(74) Mandataire: Texier, Christian
(86) Numéro de dépôt international: FR9700604
(87) Numéro de publication internationale: WO9738319

(56) Documents cités:
- EP-A- 0 660 088
- DE-A- 3 541 395
- GB-A- 564 181

## Description

La présente invention concerne le domaine des dispositifs moteur à commande électromagnétique, notamment les dispositifs connus sous le nom de "logomètre".

La présente invention trouve en particulier application dans les indicateurs à aiguille pour tableaux de bord de véhicules automobiles.

On sait que les logomètres comprennent généralement :
- deux bobines de commande croisées,
- un aimant à aimantation radiale monté à rotation dans une chambre interne définie par lesdites bobines,
- un arbre lié à l'aimant et coaxial à celui-ci, adapté pour recevoir le moyeu d'une aiguille, et
- un blindage magnétique qui entoure au moins partiellement les bobines.

Le plus souvent, les bobines de commande sont portées par un bâti support en matière plastique.

L'aimant s'oriente selon la résultante des champs magnétiques créés par les deux bobines.

Ainsi, si les deux bobines sont alimentées par des signaux représentant les sinus/cosinus ou la tangente d'une grandeur d'entrée, l'orientation angulaire de l'aimant par rapport à une position de référence, est directement représentative de cette grandeur d'entrée.

Jusqu'ici le blindage magnétique a été réalisé le plus souvent sous forme d'une cloche cylindrique en métal.

Par ailleurs, la position de repos de l'équipage mobile de tels moteurs à commande électromagnétique a jusqu'ici été imposée grâce à l'adjonction d'aimants auxiliaires ou de ressorts, ce qui conduit à des structures complexes.

Le document DE-A-3541395 décrit un blindage magnétique formé par enroulement en spiral d'un feuillard métallique.

Le document GB-A-564181 décrit un indicateur à aimant et bobinage qui comporte dans le blindage extérieur deux vis susceptibles d'être réglées pour contrôler la position de repos du dispositif.

La présente invention a maintenant pour but de perfectionner les moteurs à commande électromagnétique connus.

Ce but est atteint selon la présente invention grâce à un dispositif moteur à commande électromagnétique qui comporte :
- un ensemble à bobines de commande croisées (10, 20),
- un bâti (50) qui porte l'ensemble à bobines (10, 20),
- un équipage à aimant susceptible d'être entraîné à rotation par l'ensemble à bobines de commande (10, 20), et
- un blindage magnétique (100), qui entoure au moins partiellement l'ensemble à bobines (10, 20) et le bâti support.
caractérisé par le fait que le blindage (100), réalisé par emboutissage d'une feuille de métal magnétique doux comprend une jupe annulaire (110) non cylindrique de révolution.

Selon une autre caractéristique avantageuse de la présente invention, le blindage comprend une jupe annulaire, généralement cylindrique de révolution, mais possédant au moins une forme rentrante par rapport à ce cylindre de révolution.

Selon une variante, il est ainsi prévu deux formes rentrantes par rapport au cylindre de révolution. Ces formes rentrantes peuvent être formées de plans. Cependant, les formes rentrantes peuvent répondre à d'autres géométries. Les deux formes rentrantes peuvent être diaméralement opposées par rapport à l'axe du dispositif. Néanmoins, selon certaines variantes, ces deux formes rentrantes au contraire ne sont pas diamétralement opposées.

Selon une autre caractéristique avantageuse de l'invention, le blindage comprend une jupe annulaire non cylindrique de révolution possédant deux plans de symétrie perpendiculaires passant par l'axe de rotation de l'équipage.

Selon une autre variante de l'invention, la jupe annulaire du blindage a la forme générale d'une ellipse.

Selon une autre caractéristique avantageuse de l'invention, la jupe annulaire comprend deux secteurs cylindriques de révolution diamétralement opposés reliés entre eux par deux plans parallèles.

D'autres caractéristiques, buts et avantages de la présente invention apparaitront à la lecture de la description détaillée qui va suivre et en regard des dessins annexés donnés à titre d'exemple non limitatif et sur lesquels :
- la figure 1 représente une vue en plan axial d'un bâti support de logomètre conforme à la présente invention,
- la figure 2 représente une vue en bout d'un blindage magnétique conforme à la présente invention,
- la figure 3 représente une première vue en coupe de ce blindage selon le plan de coupe référencé III-III sur la figure 2,
- la figure 4 représente une seconde vue en coupe du même blindage selon le plan de coupe référencé IV-IV sur la figure 3, et
- la figure 5 représente une vue schématique éclatée d'un logomètre conforme à la présente invention.

La structure générale interne du logomètre comprenant des bobines 10, 20, un aimant 200 et un arbre 210 porteur d'aiguille, connu en soi, ne sera pas décrite dans le détail par la suite.

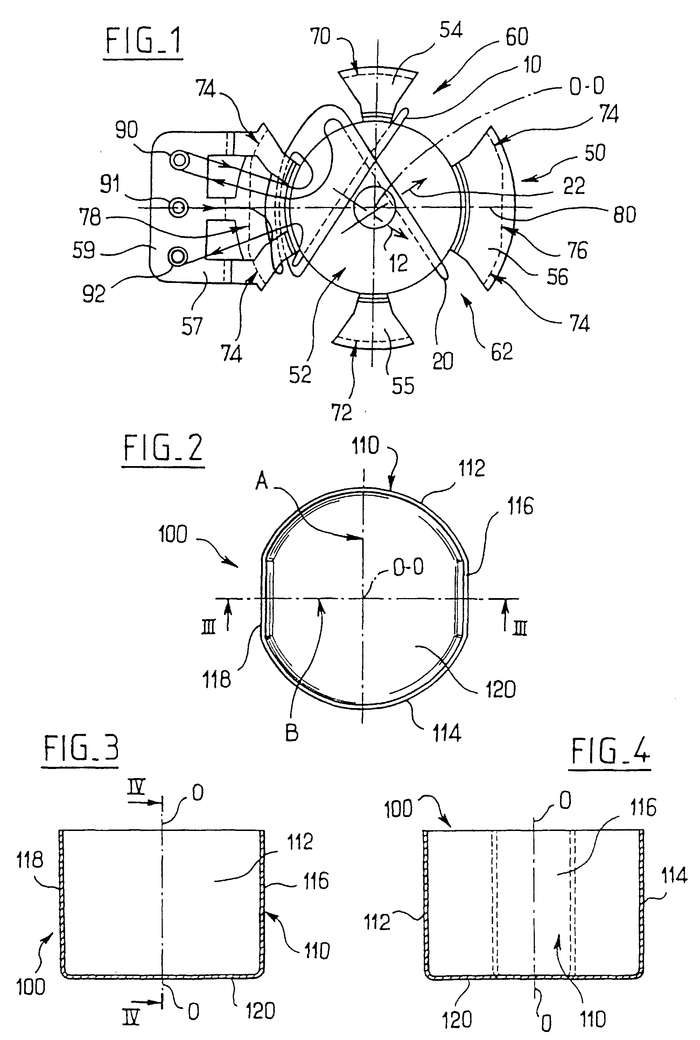

Les deux bobines 10, 20 sont placées sur un bâti support 50 représenté sur là figure 1.

De préférence, le bâti support 50 est réalisé par moulage en matière plastique. Ce bâti 50 définit un moyeu central 52 centré sur l'axe de rotation O-O de l'équipage mobile et deux paires de saillies 54, 55, 56, 57 disposées en croix. Les saillies de chaque paire 54, 55 d'une part, et 56, 57 d'autre part sont diamétralement opposées entre elles, les saillies de la seconde paire 56, 57 étant orthogonales à celles de la première 54, 55, en référence à l'axe central O-O. Les saillies précitées 54, 55, 56, 57 s'étendent dans une direction générale radiale par rapport à l'axe O-O. Il est ainsi défini entre les deux paires de saillies 54, 55 et 56, 57 deux logements annulaires 60, 62 adaptés pour recevoir les bobinages 10, 20 respectivement eux-mêmes centrés sur des axes 12, 22 orientés transversalement à l'axe central O-O.

Le moyeu 52 est adapté pour assurer le guidage de l'équipage mobile 202 comprenant l'aimant 200 et l'arbre 210 porteur d'aiguille.

Les deux saillies 54, 55 de la première paire définissent sur leur périphérie extérieure des calottes cylindriques 70, 72 de même rayon centrées sur l'axe O-O. Les deux saillies 56, 57 de la seconde paire peuvent définir également des sections de calottes cylindriques 74, de même rayon. Cependant, comme on le voit sur la figure 1, ces deux dernières saillies 56, 57 définissent en outre sur leur périphérie extérieure deux plans 76, 78 parallèles entre eux et diamétralement opposés par rapport à l'axe O-O.

Le bâti 50 définit en outre une butée interne (non représentée sur la figure 1 pour simplifier l'illustration) adaptée pour coopérer avec l'équipage mobile, par exemple l'aimant, afin de limiter l'angle de rotation de celui-ci.

Selon la représentation donnée sur la figure 1 annexée, les deux bobines 10, 20 sont inclinées entre elles de 110°. Cette inclinaison ne doit cependant pas être considérée comme limitative. Elle peut aisément être adaptée en fonction de l'application souhaitée.

Selon la présente invention, le logomètre comprend un blindage 100 du type illustré sur les figures 2 à 4, comprenant une jupe périphérique annulaire 110 centrée sur l'axe de rotation O-O et complétée par une paroi 120 en forme de disque orthogonale à cet axe O-O. Selon l'invention, la jupe périphérique annulaire 110 présente deux plans de symétrie A, B passant par l'axe de rotation O-O de l'équipage.

Le blindage 100 est réalisé en un métal magnétique doux, et de préférence par emboutissage. Plus précisément, le blindage 100 est réalisé de préférence à l'aide d'une feuille en alliage fer-nickel, par exemple 64% fer et 36% nickel.

La paroi de fond 120 du blindage 100 peut être munie de passages pour des broches reliées aux bobinages 10, 20. Cependant, de préférence, comme on le voit sur la figure 1, la connectique des bobinages 10, 20 est réalisée à l'aide de broches 90, 91, 92 raccordées aux extrémités des bobinages 10, 20 et portées par une excroissance 59 prolongeant la saillie 57, laquelle excroissance 59 est disposée sur l'extérieur du blindage 100, à proximité de son contour d'ouverture.

Selon le mode de réalisation particulier du blindage 100 illustré sur les figures 2 à 4, ce blindage 100 comprend au niveau de sa jupe périphérique annulaire 110 deux secteurs cylindriques 112, 114 diamétralement opposés, centrés sur l'axe O-O, reliés entre eux par deux plans 116, 118 parallèles entre eux et à l'axe O-O et également diamétralement opposés par rapport à ce dernier. Les plans 116, 118 sont parallèles au plan de symétrie A et perpendiculaires au plan de symétrie B.

L'ouverture angulaire des secteurs 112, 114 est avantageusement de l'ordre de 150°.

Le rayon des secteurs cylindriques 112, 114 est complémentaire du rayon des calottes cylindriques 70, 72 et 74. En outre, la distance séparant les plans 116, 118 de l'axe O-O est complémentaire de la distance séparant les plans 76, 78 formés sur le bâti 50 du même axe O-O.

Ainsi, l'homme de l'art comprendra que le blindage 100 peut aisément être fixé sur le bâti 50, par exemple par collage, soudage ultrasons, sertissage à chaud, etc ... ou tout moyen équivalent évitant la déformation du blindage 100.

On notera que selon une autre caractéristique avantageuse de l'invention, les axes 12, 22 des bobines 10, 20 ne sont pas orthogonaux aux plans 116, 118 du blindage. A titre d'exemple non limitatif, les axes 12, 22 des bobinages 10, 20 sont inclinés de l'ordre de 35° par rapport au plan de symétrie 80, B, perpendiculaire aux plans 116, 118 du blindage.

Cette caractéristique permet d'obtenir un angle de rotation de l'équipage mobile autour de l'axe O-O supérieur à celui qui résulterait de la simple commande par le champ généré par les bobines 10, 20 en présence d'un blindage 100 cylindrique de révolution.

Ainsi, lorsque la bobine 10 est alimentée, en présence d'un blindage 100 cylindrique de révolution, l'aimant de l'équipage mobile s'alignerait sur l'axe 12 de ladite bobine 10. Cependant, en raison de la présence des plans 116, 118 sur le blindage 100, l'axe de l'aimant porté par l'équipage mobile tend à prendre une position intermédiaire entre l'axe 12 de cette bobine 10 et l'axe 80 orthogonal aux plans 116, 118.

Il en résulte un retard, dans le sens trigonométrique, de la position de l'équipage mobile par rapport à la commande imposée par la seule bobine 10.

L'effet inverse est obtenu lorsque la bobine 20 est alimentée. En effet, si en présence d'un blindage cylindrique de révolution, l'axe de l'aimant de l'équipage mobile s'alignerait sur l'axe 22 de la bobine 20 lors de l'alimentation de celle-ci, avec un blindage 100 conforme à l'invention, l'axe de l'aimant de l'équipage mobile prend une position intermédiaire entre cet axe 22 de la bobine 20 et le plan 80 précité orthogonal aux plans 116 et 118 du blindage. On obtient alors une avance, dans le sens trigonométrique, de l'équipage mobile par rapport à l'axe 22 de la seule bobine 20.

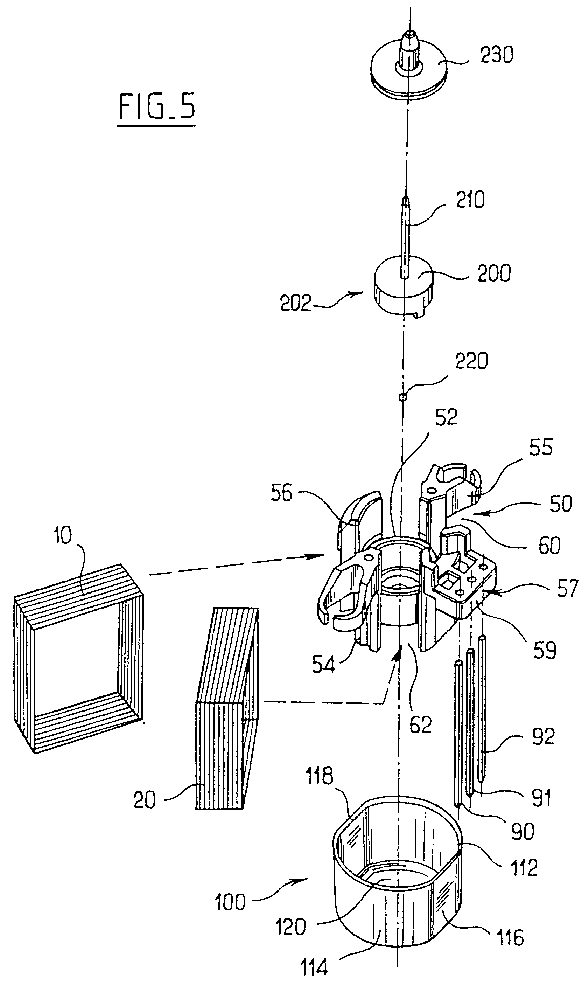

On distingue en outre sur la figure 5 une bille 220 placée dans une chambre centrale du fond du bati 50 pour servir d'appui à une extrémité de l'axe 210 solidaire de l'aimant 200, et un support d'axe 230 adapté pour être fixé sur le bati 50 et guidé la seconde extrémité de l'axe 210.

Le fonctionnement général du logomètre illustré sur les figures annexées est le suivant.

Les bobinages 10, 20 sont alimentés par des signaux classiques tenant compte de la géométrie des bobinages, plus précisément de l'inclinaison relative de ceux-ci et de la réluctance du blindage 100.

Les deux bobines 10, 20 créent un champ donnant un couple si l'on écarte l'aimant 200 de sa position. Par ailleurs, le blindage 100 crée lui aussi un couple en raison de sa dissymétrie de révolution. Et les positions stables de ces deux couples ne sont pas confondues. L'angle occupé par l'aimant 200 est celui qui correspond à une somme nulle de ces deux couples.

Lors de la coupure de l'alimentation, en raison de la réluctance variable du blindage 100 due à sa dissymétrie de révolution, l'aimant de l'équipage mobile tend à s'aligner sur le plan de symétrie 80 orthogonal aux plans 116, 118 et vient ainsi en appui, sans rebond, sur la butée mécanique prévue dans le logomètre.

Le logomètre conforme à la présente invention offre de nombreux avantages par rapport aux dispositifs antérieurement connus.

Tout d'abord on notera que le logomètre conforme à la présente invention présente une parfaite symétrie par rapport au plan 80. Il peut par conséquent être entraîné sans aucune difficulté selon les deux sens de rotation opposés et ce avec la même courbe de réponse angle/commande quel que soit le sens de rotation. Ceci représente un avantage important par rapport aux logomètres antérieurs à rappel par aimant ou par spiral qui présentaient des courbes de réponse dissymétriques selon le sens de rotation.

En outre, le logomètre conforme à la présente invention permet d'augmenter l'amplitude de rotation de l'équipage mobile par rapport à celle résultant de la seule commande des bobines 10, 20.

Enfin, le logomètre conforme à la présente invention est de fabrication et- d'assemblage simples et ne requiert pas de changement fondamental dans les chaînes de fabrication ou d'implantation.

Comme on l'a indiqué précédemment, d'une façon plus générale le blindage 100 conforme à la présente invention comprend une jupe annulaire 110 généralement cylindrique de révolution possédant au moins une forme rentrante (par exemple un plan ou une autre forme) par rapport à ce cylindre de révolution. Il peut s'agir de deux formes rentrantes diamétralement opposées ou non.

Selon encore une autre variante le blindage 100 peut présenter, en section, une forme générale d'ellipse.

## Revendications

1. Dispositif moteur à commande électromagnétique, notamment logomètre du type comportant :
- un ensemble à bobines de commande croisées (10, 20),
- un bâti (50) qui porte l'ensemble à bobines (10, 20),
- un équipage à aimant susceptible d'être entrainé à rotation par l'ensemble à bobines de commande (10, 20), et
- un blindage magnétique (100), qui entoure au moins partiellement l'ensemble à bobines (10, 20) et le bâti support,
caractérisé par le fait que le blindage (100), réalisé par emboutissage d'une feuille de métal magnétique doux comprend une jupe annulaire (110) non cylindrique de révolution.

2. Dispositif selon la revendication 1, caractérisé par le fait que le blindage (100) comprend une jupe annulaire (110), généralement cylindrique de révolution, mais possédant au moins une forme rentrante (116, 118) par rapport à ce cylindre de révolution.

3. Dispositif selon la revendication 2, caractérisé par le fait que le blindage (100) comprend deux formes rentrantes (116, 118) par rapport au cylindre de révolution.

4. Dispositif selon la revendication 3, caractérisé par le fait que les formes rentrantes (116, 118) sont formées de plans.

5. Dispositif selon l'une des revendications 3 ou 4, caractérisé par le fait que les deux formes rentrantes (116, 118) sont diamétralement opposées par rapport à l'axe du dispositif.

6. Dispositif selon l'une des revendications 3 ou 4, caractérisé par le fait que les deux formes rentrantes (116, 118) ne sont pas diamétralement opposées par rapport à l'axe du dispositif.

7. Dispositif selon l'une des revendications 1 à 6, caractérisé par le fait que le blindage (100) comprend une jupe annulaire (110) non cylindrique de révolution possédant deux plans de symétrie orthogonaux (A, B) passant par l'axe de rotation (O-O) de l'équipage.

8. Dispositif selon l'une des revendications 1 à 5 et 7, caractérisé par le fait que la jupe annulaire (110) comprend deux secteurs cylindriques de révolution (112, 114) diamétralement opposés reliés entre eux par deux plans parallèles (116, 118).

9. Dispositif selon l'une des revendications 1 à 8, caractérisé par le fait que les axes (12, 22) des bobinages (10, 20) ne sont pas orthogonaux aux plans (116, 118) du blindage (110).

10. Dispositif selon l'une des revendications 1 à 9, caractérisé par le fait que les axes (12, 22) des bobinages (10, 20) sont inclinés de l'ordre de 35° par rapport à un plan de symétrie (80) perpendiculaire aux plans (116, 118) du blindage (100).

11. Dispositif selon l'une des revendications 1 à 10, caractérisé par le fait que les bobinages (10, 20) sont inclinés entre eux de l'ordre de 110°.

12. Dispositif selon l'une des revendications 1 à 11, caractérisé par le fait que le blindage (100) est en acier doux.

13. Dispositif selon l'une des revendications 1 à 12, caractérisé par le fait que l'ouverture angulaire de secteurs cylindriques (112, 114) du blindage (100) est de l'ordre de 150°.

14. Dispositif selon l'une des revendications 1 à 13, caractérisé par le fait que le blindage (100) comprend une jupe annulaire de section en forme générale d'ellipse.

## Patentansprüche

1. Elektromagnetisch gesteuerter Motors, insbesondere von der Art eines Logometers, der folgendes aufweist:
- einen Satz gekreuzter Wicklungen (10, 20) für die Betätigung;
- ein Gestell (50), auf dem die Wicklungen (10, 20) montiert sind;
- eine mobiles Organ mit einem Magneten, welches mit Hilfe der Wicklungen (10, 20) drehbar angetrieben werden; und
- eine magnetische Abschirmung (100), die mindestens teilweise die Wicklungen (10, 20) und das Gestell umgibt,
**dadurch gekennzeichnet, dass**
die Abschirmung (100), welche durch Tiefziehen eines weichen magnetischen Metallbleches hergestellt wird, eine ringförmige nicht zylindrisch drehbare Ummantelung (110) enthält.

2. Vorrichtung nach Anspruch 1,
**dadurch gekennzeichnet, dass**
die Abschirmung (100) eine ringförmige allgemein zylindrisch drehbare Ummantelung (110) enthält, die jedoch mindestens eine gegenüber diesem Rotationszylinder nach innen eingezogene Form (116, 118) aufweist.

3. Vorrichtung nach Anspruch 2,
**dadurch gekennzeichnet, dass**
die Abschirmung (100) zwei gegenüber dem Rotationszylinder eingezogene Formen (116,118) aufweist.

4. Vorrichtung nach Anspruch 3,
**dadurch gekennzeichnet, dass**
die eingezogenen Formen (116,118) aus Flächen bestehen.

5. Vorrichtung nach einem der Ansprüche 3 oder 4,
**dadurch gekennzeichnet, dass**
die beiden eingezogenen Formen (116, 118) diametral gegenüberliegend zu der Welle der Vorrichtung angeordnet sind.

6. Vorrichtung nach einem der Ansprüche 3 oder 4,
**dadurch gekennzeichnet, dass**
die beiden eingezogenen Formen (116, 118) nicht diametral gegenüberliegend zu der Welle der Vorrichtung angeordnet sind.

7. Vorrichtung nach einem der Ansprüche 1 bis 6,
**dadurch gekennzeichnet, dass**
die Abschirmung (100) eine nicht zylindrisch drehbare ringförmige Ummantelung (110) mit zwei orthogonalen Symmetrieebenen (A, B) enthält, welche die Rotationsachse (0-0) des mobilen Organs schneiden.

8. Vorrichtung nach einem der Ansprüche 1 bis 5 und 7,
**dadurch gekennzeichnet, dass**
die ringförmige Ummantelung (110) zwei diametral gegenüberliegende zylindrisch drehbare Abschnitte (112, 114) aufweist, die mit Hilfe von zwei parallelen Flächen (116,118) miteinander verbunden sind.

9. Vorrichtung nach einem der Ansprüche 1 bis 8,
**dadurch gekennzeichnet,dass**
die Wellen (12, 22) der Wicklungen (10, 20) nicht orthogonal zu den Flächen (116,118) der Abschirmung (110) liegen.

10. Vorrichtung nach einem der Ansprüche 1 bis 9,
**dadurch gekennzeichnet, dass**
die Wellen (12, 22) der Wicklungen (10, 20) in einem Winkel von etwa 35° gegenüber einer Symmetrieebene (80) geneigt sind, welche senkrecht zu den Flächen (16, 118) der Abschirmung (100) liegt.

11. Vorrichtung nach einem der Ansprüche 1 bis 10,
**dadurch gekennzeichnet, dass**
die Wicklungen (10, 20) zueinander in einem Winkel von 110° geneigt angeordnet sind.

12. Vorrichtung nach einem der Ansprüche 1 bis 11,
**dadurch gekennzeichnet, dass**
die Abschirmung (100) aus einem weichen Stahl hergestellt ist.

13. Vorrichtung nach einem der Ansprüche 1 bis 12,
**dadurch gekennzeichnet, dass**
die Winkelöffnung der zylindrischen Abschnitte (112,114) der Abschirmung (110) in der Größenordnung von 150° liegt.

14. Vorrichtung nach einem der Ansprüche 1 bis 13,
**dadurch gekennzeichnet, dass**
die Abschirmung (100) eine ringförmige Ummantelung mit den allgemeinen Querschnitt einer Ellipse aufweist.

## Claims

1. An electromagnetically controlled drive device, in particular a ratio meter, of the type comprising:
· a set of crossed control coils (10, 20);
· a frame (50) which carries the set of coils (10, 20);
· equipment including a magnet suitable for being pivoted by the set of control coils (10, 20); and
· magnetic shielding (100) surrounding the set of coils (10, 20) and the support frame, at least in part,
the device being characterized by the fact that the shielding (100) which is made by stamping a sheet of soft magnetic metal, comprises an annular skirt (110) that is not a circular cylinder.

2. A device according to claim 1, characterized by the fact that the shielding (100) comprises an annular skirt (110) that is generally a circular cylinder, but that possesses at least one re-entrant shape (116, 118) that is re-entrant relative to the circular cylinder.

3. A device according to claim 2, characterized by the fact that the shielding (100) has two re-entrant shapes (116, 118) that are re-entrant relative to the circular cylinder.

4. A device according to claim 3, characterized by the fact that the re-entrant shapes (116, 118) are formed by planes.

5. A device according to claim 3 or 4, characterized by the fact that the two re-entrant shapes (116, 118) are diametrically opposite about the axis of the device.

6. A device according to claim 3 or 4, characterized by the fact that the two re-entrant shapes (116, 118) are not diametrically opposite about the axis of the device.

7. A device according to any one of claims 1 to 6, characterized by the fact that the shielding (100) comprises an annular skirt (110) that is not a circular cylinder and that possesses two orthogonal planes of symmetry (A, B) intersecting on the axis of rotation (O-O) of the equipment.

8. A device according to any one of claims 1 to 5 and 7, characterized by the fact that the annular skirt (110) comprises two diametrically-opposite sectors (112, 114) of a circular cylinder interconnected by two parallel planes (116, 118).

9. A device according to any one of claims 1 to 8, characterized by the fact that the axes (12, 22) of the coils (10, 20) are not orthogonal to the planes (116, 118) of the shielding (110).

10. A device according to any one of claims 1 to 9, characterized by the fact that the axes (12, 22) of the coils (10, 20) are inclined by about 35° relative to a plane of symmetry (80) perpendicular to the planes (116, 118) of the shielding (100).

11. A device according to any one of claims 1 to 10, characterized by the fact that the coils (10, 20) are inclined relative to each other by about 110°.

12. A device according to any one of claims 1 to 11, characterized by the fact that the shielding (100) is made of soft steel.

13. A device according to any one of claims 1 to 12, characterized by the fact that the angular extent of each of the cylindrical sectors (112, 114) of the shielding (100) is about 150°.

14. A device according to any one of claims 1 to 13, characterized by the fact that the shielding (100) comprises an annular skirt of section that is generally elliptical in shape.
